(19) **Europäisches Patentamt / European Patent Office / Office européen des brevets**

(11) **EP 4 656 780 A1**

(12) # EUROPEAN PATENT APPLICATION
published in accordance with Art. 153(4) EPC

(43) Date of publication:
**03.12.2025   Bulletin 2025/49**

(21) Application number: **23941429.5**

(22) Date of filing: **29.12.2023**

(51) International Patent Classification (IPC):
**C30B 29/36** (2006.01)      **C30B 23/00** (2006.01)
**C30B 23/02** (2006.01)

(52) Cooperative Patent Classification (CPC):
**C30B 23/00; C30B 23/02; C30B 25/18;**
**C30B 27/00; C30B 29/36; H01L 21/04**

(86) International application number:
**PCT/CN2023/143064**

(87) International publication number:
**WO 2024/255209 (19.12.2024 Gazette 2024/51)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **15.06.2023   CN 202310712510**

(71) Applicant: **SICC CO., LTD.**
**Jinan, Shandong 250118 (CN)**

(72) Inventors:
- **ZHANG, Jiuyang**
  **Jinan, Shandong 250118 (CN)**
- **SU, Lina**
  **Jinan, Shandong 250118 (CN)**
- **ZHANG, Weigang**
  **Jinan, Shandong 250118 (CN)**
- **LI, Hao**
  **Jinan, Shandong 250118 (CN)**
- **CHEN, Yanchang**
  **Jinan, Shandong 250118 (CN)**

- **LV, Kexin**
  **Jinan, Shandong 250118 (CN)**
- **GAO, Chao**
  **Jinan, Shandong 250118 (CN)**
- **ZHAO, Shuchun**
  **Jinan, Shandong 250118 (CN)**
- **LIANG, Qingrui**
  **Jinan, Shandong 250118 (CN)**
- **ZHANG, Hongyan**
  **Jinan, Shandong 250118 (CN)**
- **SUN, Yuanhang**
  **Jinan, Shandong 250118 (CN)**
- **LIU, Yaohua**
  **Jinan, Shandong 250118 (CN)**
- **MA, Long**
  **Jinan, Shandong 250118 (CN)**
- **MA, Jie**
  **Jinan, Shandong 250118 (CN)**
- **LI, Xianglin**
  **Jinan, Shandong 250118 (CN)**

(74) Representative: **Chung, Hoi Kan**
**Mandarin IP Limited**
**7 Cherry Trees**
**Great Shelford**
**Cambridge CB22 5XA (GB)**

(54) **SILICON CARBIDE SUBSTRATE HAVING HIGH CRYSTAL QUALITY**

(57)   A silicon carbide substrate having high crystal quality, belonging to the technical field of silicon carbide production and processing. The silicon carbide substrate comprises a first main surface and a second main surface; the first main surface has a central area and an annular area surrounding the central area, the width of the annular area extending inward from an edge of the substrate being 5-30 mm; the central area is divided into square areas, each having a side length of 5 mm, the internal stress of each square area being less than the internal stress of the annular area, and the internal stress being the stress value detected at least 30 $\mu$m vertically extending from the first main surface or the second main surface into the silicon carbide substrate. The internal stress in the central area of the silicon carbide substrate is relatively low, and the stress on the substrate can be evenly distributed, proving that the quality of the silicon carbide substrate is high and subsequent crystal quality can be improved, thereby expanding the scope of use of the silicon carbide substrate.

EP 4 656 780 A1

FIG. 1

**Description**

TECHNICAL FIELD

The present application relates to a silicon carbide substrate having high crystal quality, belonging to the technical field of silicon carbide production and processing.

BACKGROUND

Silicon carbide single-crystal substrate is a preferred semiconductor material for the fabrication of GaN-based high-frequency microwave devices because of its excellent physical properties, such as large forbidden band width, high resistivity and thermal conductivity, and high breakdown field strength. With the continuous development of 5G technology, the market demand for silicon carbide single crystal substrates continues to expand, and more important, mass commercial applications of silicon carbide single crystal substrates put forward higher requirements for the quality.

In the growth process of silicon carbide crystal, various defects such as polycrystal, polytype, micropipe, dislocation and so on are easily introduced into the crystal due to the imbalance of Si/C ratio, impurity introduction and temperature gradient change. The defects will cause lattice distortion, and the crystal form will be transformed more seriously, such as 4H, 6H, 3C, 15R and so on polytype symbiosis. The lattice distortion releases the stress by generating defects, i. e., the internal stress is introduced into the silicon carbide, thereby reducing the crystal quality of silicon carbide, limiting the scope of crystal use, and reducing the yield of products. In addition, due to the temperature field or the existence of defects, the internal stress of the silicon carbide substrate can easily affect the overall quality, but there is a phenomenon of stress concentration in a certain area, so that the stress distribution of the obtained silicon carbide substrate is uneven, thus affecting the production and processing of downstream products. When the silicon carbide substrate is used for crystal or epitaxial layer growth, it will be inherited to the crystal or epitaxial layer, causing stress concentration of the crystal or epitaxial layer.

SUMMARY

In order to solve the above-mentioned problems, a silicon carbide substrate having a high crystal quality is provided. The silicon carbide substrate is divided into a central area and an annular area, wherein the central area can be divided into a plurality of square areas with a side length of 5 mm, which can not only meet the detection accuracy, but also can divide the substrate into regions to quantitatively analyze whether there is a phenomenon of stress concentration on the substrate. The internal stress of each square area is less than that of the annular area, which proves that the internal stress of the central area of the silicon carbide substrate is relatively low. Also, the stress on the substrate can be uniformly distributed, which proves that the silicon carbide substrate has a high quality, expanding the use of silicon carbide substrates. The silicon carbide substrate can be used for processing to obtain epitaxial wafers or as seed crystals for growing crystals, and improve the subsequent crystal quality, thereby reducing the stress on the epitaxial wafers or crystals to obtain high quality epitaxial wafers or crystals.

According to one aspect of the present application, a silicon carbide substrate with a high crystal quality is provided, wherein the diameter of the silicon carbide substrate is 150 mm or more; the silicon carbide substrate includes a first main surface and a second main surface;

the first main surface has a central area and an annular area surrounding the central area, the width of the annular area extending inward from an edge of the substrate being 5-30 mm; and

the central area is divided into square areas, each having a side length of 5 mm, the internal stress of each square area being less than the internal stress of the annular area, and the internal stress being the stress value detected at least 30 $\mu$m vertically extending from the first main surface or the second main surface into the silicon carbide substrate.

The internal stress of the annular area is greater than the internal stress of each of the square areas in the central area, the smaller the width of the annular area extending inwardly from the edge of the substrate, demonstrating that the greater the area of the central area, the smaller the internal stress of the silicon carbide substrate. If the annular area has an excessive internal stress, a portion of the crystal in the annular area may be cut away in actual use, leaving only the silicon carbide crystal in the central area, and a silicon carbide substrate with a higher quality may be obtained.

Alternatively, at any plane parallel to the first and/or second main surfaces, the radial internal stress of the square area is -10 to 10 MPa and the radial internal stress of the annular area is 5 to 15 MPa.

Preferably, the radial internal stress of the square area is -9.4 to 9.2 MPa and the radial internal stress of the annular area is 5 to 14.7 MPa.

Since the tensile and compressive stress in the silicon carbide substrate results in a corresponding stretching and shrinking change of the interplanar spacing d, when Raman is used to test the stress, the Raman peak intensity will shift to a low frequency or a high frequency. When the tensile stress is applied in the substrate, the Raman peak shifts to a low frequency, and the obtained stress value is a positive value. When the compressive stress is applied in the substrate, the Raman peak shifts to a high frequency, and the obtained stress value is a negative value. Therefore, the positive and negative values in front of the stress value in the present application represent the force direction in the substrate, and the absolute value of the value represents the magnitude of the stress. For example, when the radial stress in the square area of the silicon carbide substrate is -5 MPa and the radial internal stress in the annular area is 6 MPa, it means that the radial internal stress in the square area is a compressive stress, the radial internal stress in the annular area is a tensile stress, and the radial internal stress in the square area is less than the radial internal stress in the first annular area.

According to the radial internal stress values in the square area and the annular area, it can be seen that the compressive stress and tensile stress exist in the square area, while the annular area is a tensile stress region. The closer the value of the square area is to that of the annular area, the more uniform the radial internal stress distribution of the silicon carbide substrate is.

Alternatively, at any plane parallel to the first main surface and/or the second main surface, $S_{max1}$ represents a maximum value of an absolute value of the radial internal stress in all of the square areas, and $S_{max2}$ represents a maximum value of the absolute value of the radial internal stress in the annular area, 1.8 MPa $\leq S_{max2}$ - $S_{max1} \leq$ 5.2 MPa.

Alternatively, at any plane parallel to the first main surface and/or the second main surface, S1 represents an average value of absolute values of radial internal stresses in all of the square areas, and S2 represents an average value of absolute values of radial internal stresses in any of the square areas, -5 MPa $\leq$ S1 - S2 $\leq$ 5 MPa.

A multi-point detection is performed on the silicon carbide substrate. The above-mentioned average value of absolute values refers to a value obtained by dividing the sum of the absolute values of stresses at all the detection points in the area by the number of detection points. The multi-point detection may be performed by selecting a plurality of points at different positions in the area for detection, or by performing a Mapping test on the substrate.

Preferably, -4.8 MPa $\leq$ S1 - S2 $\leq$ 4.9 MPa. More preferably, -2.4 MPa $\leq$ S1 - S2 $\leq$ 3.3 MPa. The above-mentioned difference S1 - S2 represents the difference between the overall stress in the central area and the stress in each square area. The smaller the difference is, the more uniform the stress distribution in the central area.

Alternatively, at any plane parallel to the first main surface and/or the second main surface, S1 represents an average value of absolute values of radial internal stress in all of the square areas, S3 represents an average value of absolute values of radial internal stresses in the annular area, 0.3 $\leq$ S1/S3 $\leq$ 0.94.

Preferably, 0.31 $\leq$ S1/S3 $\leq$ 0.94. The S1/S3 ratio represents the difference in radial internal stress between the central area and the annular area. When the ratio is closer to 1, it proves that the smaller the difference between the annular area and the central area is, the more uniform the radial internal stress distribution of the silicon carbide substrate is.

Optionally, at any plane parallel to the first main surface and/or the second main surface, $S_{max3}$ represents a maximum value of radial internal stresses in any of the square areas, and $S_{min3}$ represents a minimum value of radial stresses in any of the square areas, $\Delta S_1 = S_{max3}$ - $S_{min3}$, 0 MPa $\leq \Delta S_1 \leq$ 10 MPa;

$S_{max4}$ represents a maximum value of radial internal stresses in the annular area, and $S_{min4}$ represents a minimum value of the radial stresses in the annular area, $\Delta S_2 = S_{max4}$ - $S_{min4}$, 0 MPa $\leq \Delta S_2 \leq$ 5 MPa, at any plane parallel to the first and/or second main surfaces.

Preferably, 0 MPa $\leq \Delta S_1 \leq$ 9.5 MPa, 0.1 MPa $\leq \Delta S_2 \leq$ 4.9 MPa.

The above-mentioned maximum value and minimum value of the radial internal stress refer to real values of the radial internal stress, and the compressive stress and the tensile stress are distinguished. For example, at any horizontal plane parallel to the first main surface and/or the second main surface, the radial internal stress of a square area is - 5 MPa to 2 MPa, and the maximum value of the radial integrated stress is 2 MPa. The minimum value of the radial integrated stress is -5 MPa. $\Delta S_1$ is 7 MPa. $\Delta S_1$ and $\Delta S_2$ represent the degree of change between interplanar spacings in the radial direction of a substrate on a microscopic scale. The smaller the above-mentioned $\Delta S_1$ and $\Delta S_2$ are, the smaller the variation of the interplanar spacing in the radial direction is.

Optionally, the square area has an axial internal stress of -10 to 10 MPa and the annular area has an axial internal stress of -15 to 15 MPa when tested in an axial direction extending perpendicularly into the silicon carbide substrate from any point of the first main surface.

Preferably, the radial internal stress of the square area is -5 to 5 MPa and the radial internal stress of the annular area is -10 to 10 MPa.

Optionally, an axial test is performed extending perpendicularly into the silicon carbide substrate from any point of the first main surface; $S_{max5}$ is recorded as a maximum value of the axial stresses of the square area on the axis, and $S_{min5}$ is recorded as a minimum value of the axial stresses of the square area on the axis, $\Delta S_3 = S_{max5}$ - $S_{min5}$, 0 MPa $\leq \Delta S_3 \leq$ 10 MPa;

an axial test is performed extending perpendicularly into the silicon carbide substrate from any point of the first main surface, wherein $S_{max6}$ is recorded as a maximum value of the axial stresses in the annular area, and $S_{min6}$ is recorded as a minimum value of the axial stresses in the annular area, $\Delta S_4 = S_{max6}$ - $S_{min6}$, 0 MPa $\leq \Delta S_4 \leq$ 15 MPa.

Preferably, 0.1 MPa $\leq \Delta S_3 \leq$ 9.7 MPa, 0.3 MPa $\leq \Delta S_4 \leq$ 14.3 MPa.

The meaning of the above-mentioned maximum value of the axial internal stress and the minimum value of the axial internal stress is the same as the meaning of the maximum value of the radial internal stress and the minimum value of the radial internal stress, and the compressive stress and the tensile stress are distinguished in the axial direction. For example, on an arbitrary axis, the axial internal stress of a square area is -5-1 MPa, and the maximum value of the axial internal stress is 1 MPa. The minimum value of the axial internal stress is -5 MPa, and $\Delta S_3$ is 6 MPa. $\Delta S_3$ and $\Delta S_4$ represent the degree of change between interplanar spacings in the axial direction of a substrate on a microscopic scale. The smaller the above-mentioned $\Delta S_3$ and $\Delta S_4$ are, the smaller the variation of the interplanar spacing of the substrate in the axial direction is.

Alternatively, S4 represents an average value of absolute values of axial internal stresses in all of the square areas, and S5 represents an average value of absolute values of radial internal stresses in any of the square areas, -5 MPa $\leq$ S4 - S5 $\leq$ 5 MPa, preferably, - 4.2 MPa $\leq$ S4 - S5 $\leq$ 4.8 MPa.

Alternatively, S4 represents an average value of absolute values of the axial internal stresses in all of the square areas, and S6 represents an average value of absolute values of the axial internal stresses in the annular areas, 0.1 $\leq$ S4/S6 $\leq$ 0.8, preferably 0.1 $\leq$ S4/S6 $\leq$ 0.79.

The stress values described in the present application refer to absolute stress and relative stress, and the absolute stress can reflect the difference between a substrate and a perfect SiC crystal without defects, so as to determine the stress level of a SiC substrate. However, since it is difficult to achieve a perfect SiC-free substrate in today's technology, the relative stress distribution in the substrate plane can be judged by the relative stress.

For example, when the absolute stress of the substrate is larger and the relative stress is smaller, it means that there are more in-plane defects, but the stress distribution is uniform. The crystal quality is poor, and the uniformity quality is poor in the various areas of the substrate. If the absolute stress is smaller and the relative stress is larger, the quality of the whole substrate is better, but there is abnormal quality deviation locally.

The reference value of the absolute stress in the present application is a reference stress calculated according to a standard Raman peak position obtained from a SiC perfect lattice parameter, and is marked as 0. The relative stress is calculated by taking a reference value on the whole test plane, correlating the value of each test point with the reference value to obtain the relative stress value of the test point. The selection of the reference value includes but is not limited to any one of the results calculated for the median, mean, mode or other statistical function of all the stress values on the whole test plane.

Alternatively, the silicon carbide substrate has a diameter of 200 mm or more, the width of the annular area extending inwardly from an edge of the substrate being 5-15 mm.

Alternatively, the silicon carbide substrate has a thickness of not less than 100 $\mu$m.

Optionally, an off-angle of the first main surface and/or the second main surface with respect to the {0001} plane is 4° or less;

Preferably, the silicon carbide substrate has a degree of bending of -50 $\mu$m to 50 $\mu$m, preferably -20 $\mu$m to 20 $\mu$m, more preferably -10 $\mu$m to 10 $\mu$m.

Alternatively, the crystalline form of the silicon carbide substrate is one of 2H-SiC, 4H-SiC, 6H-SiC, 3C-SiC, and 15R-SiC, preferably 4H-SiC.

Alternatively, the silicon carbide substrate is a semi-insulating silicon carbide substrate or a conductive silicon carbide substrate.

Alternatively, the central area has a local thickness deviation of 0.1-2 $\mu$m and the annular area has a local thickness deviation of 0.1-2 $\mu$m.

According to another aspect of the present application, there is provided a method for preparing a silicon carbide single crystal, including the steps of:

(1) adding silicon carbide powder to a graphite crucible;
(2) evacuating the furnace body to less than 10-6 mbar, then introducing a high-purity inert gas to 300-500 mbar, repeating this process for 2-3 times, and finally evacuating the furnace body to less than 10-6 mbar;
(3) introducing a high-purity inert gas into the furnace body, increasing the pressure to 10-100 mbar within 1-3 h, and continuously introducing the high-purity inert gas and keeping the pressure unchanged;
(4) growing stage: keeping the pressure constant, and increasing the temperature in the furnace body to a single crystal growth temperature of 2200 K-2800 K within 3-5 h, the growth time being 30-150 h; and
(5) at the end of single crystal growth, opening the furnace body, and removing the graphite crucible to obtain a silicon carbide single crystal.

Optionally, the graphite crucible is coated with a TaC coating deposited on the surface of the graphite substrate. The TaC coating has through-type through holes uniformly distributed therein, and the density of the through-type through holes is 160-310/mm2.

The TaC coating contains through-type through holes, which can improve the temperature field uniformity of the crystal growth, increase the growth rate of the crystal and reduce the stress in the crystal, so as to obtain a silicon carbide crystal with high quality and low stress.

Alternatively, the through-type through hole has a pore diameter of 2-7 $\mu$m, preferably 2.3-6.1 $\mu$m. The pore size can increase the transmission rate of the silicon carbide raw material atmosphere without reducing the protective performance of the graphite substrate, and prevent the crystal from being pressed by the thermal expansion of the graphite substrate in the thermal field to generate edge stress, further reducing the stress in the crystal.

Alternatively, the TaC coating has a thickness of 30-400 $\mu$m, the TaC grains in the TaC coating are arranged in a stacked staggered manner, and the TaC grains have a size of 15-50 $\mu$m. The TaC grains in the TaC coating are oriented in and directions. The growth direction of the TaC grains can improve the temperature resistance and thermal chemical resistance of the TaC coating, thereby reducing the interference of the graphite substrate on the crystal growth environment and improving the stability of the crystal environment.

Benefits of the present disclosure include, but are not limited to the followings.

1. A thermal stress of a growing crystal and a residual stress caused by defects in the silicon carbide crystal exist in the silicon carbide crystal. The residual stress is an internal stress of the silicon carbide substrate. The internal stress in the central area of the silicon carbide substrate in the present application is less than that in the annular area, which proves that the quality of the silicon carbide substrate is better, and is beneficial to the production and processing of downstream products.

2. The radial internal stress of the annular area of the silicon carbide substrate in the present application is relatively small. According to the stress values of each square area in the annular area and the central area, it can be seen that the annular area can have both tensile stress and compressive stress, and the annular area only has tensile stress. Therefore the stress distribution of the silicon carbide substrate can be controlled within a reasonable range according to the difference in downstream products used for the preparation of the silicon carbide substrate, so as to expand the scope of use of the silicon carbide substrate.

3. According to the silicon carbide substrate of the present application, the distribution of the radial stress and the axial stress in each square area in the central area is uniform, which proves that the silicon carbide substrate has a good uniformity, and the radial stress difference between the central area and the annular area is also small.

4. In the present application, using the TaC coating with a through-type through hole formed on the surface of the crucible can ensure the transmission of a raw material atmosphere during crystal growth and at the same time improve the uniformity of a temperature field, thereby reducing the internal stress of the silicon carbide substrate and reducing the difference between the central area and the annular area of the silicon carbide substrate.

5. According to the information about the stress distribution of the silicon carbide substrate in the central area and the annular area as well as the information about the stress distribution of each square area in the central area in the present application, the unit cell parameters of the substrate on a microscopic level can be analyzed from the stress value, so as to play a certain feedback role to adjust various process parameters of crystal growth, thereby preparing a silicon carbide substrate with high quality.

6. By the quantitative test method of the present application, the detected stress also includes the stress in the substrate where the lattice distortion has not been released by a defect, improving the detection accuracy of the stress in the silicon carbide substrate, reflecting all the stress information of the entire silicon carbide substrate in the central area and the annular area.

BRIEF DESCRIPTION OF DRAWINGS

The accompanying drawings, which are included to provide a further understanding of the application and are a constituent part of this application. Examples of the application and together with the description serve to explain the application and are not intended to limit the invention in any way. In the drawings,

FIG. 1 is a schematic diagram of an internal stress in substrate by a Raman equidistant focus test and a uniform focus plane test according to Example 4 of the present application.

FIG. 2 is a topographical representation of the TaC coating in a crucible 1# according to Example 5 of the present application.

DETAILED DESCRIPTION OF THE EMBODIMENTS

The present application will be described in detail below with reference to examples, but the present application is not limited to these examples.

Unless otherwise noted, the starting materials in the examples of this application are purchased commercially.

According to the stress principle of the substrate by the Raman test used in the following examples, Raman spectrometer enables monochromatic laser light of a certain wavelength to pass through a series of light paths and converge the same by an objective lens to irradiate onto the surface of the substrate, and laser photon interacts with the substrate lattice to cause photon scattering. The occurrence of Raman scattering is related to the lattice vibration of the substrate itself. When there is residual stress in the sample, tensile and compressive stress will cause the bond length of atoms to stretch or shorten accordingly, which will cause the vibration frequency of atoms to decrease or increase. In the Raman spectrum, the characteristic peak position of the substrate shifts to low frequency or high frequency, that is to say, the peak position offset appears.

Example 1 Quantitative Test Method for Substrate Stress

First, the SiC substrate is measured by single crystal XRD diffractometer and the substrate is resolved according to reciprocal lattice space. The parameters of the standard 4H-SiC substrate are calculated and compared with the standard parameters. This is followed by the Bragg diffraction equation: $2d\sin\theta = n\lambda$, where d is the interplanar spacing; $\theta$ is the diffraction half angle; n is the diffraction order; and $\lambda$ is the wavelength. By testing $\theta$ and d of different substrates, it can be seen that the tensile and compressive stresses in the crystal lead to the corresponding changes in the interplanar spacing d. According to the different interplanar spacings $d_0$ and dx, dx is divided into $d_1$ and $d_2$, where $d_0$ is the theoretical interplanar spacing; $d_1$ is the interplanar spacing after the subjection of tensile stress, and the $d_1$ is greater than $d_0$; and $d_2$ is the interplanar spacing after the subjection of compressive stress, and the $d_2$ is less than $d_0$. The interplanar spacing difference $\Delta d$ at different positions is calculated, $\Delta d = d_1 - d_0$ or $\Delta d = d_0 - d_2$.

The actual peak position of the substrate is obtained according to the Raman measurement, and the peak position offset $\Delta v$ at different test points is calculated compared with the standard peak position. By combining the Hooke's law or stress-strain formula to calculate the stress value $\sigma$ of silicon carbide substrate at different test points, the ratio of the peak shift to the stress value at different test points is the peak shift and the stress transformation coefficient $\mu$, and its range is -125 to -2500.

The calculation formula of Hooke's law is $\sigma/S = E \times (\Delta d/d_0)$, where S is the area affected by $\sigma$, and is a fixed value. When the Hooke's law is applicable to microscopic calculation, S is the microscopic area, which can be counted as unit 1. E is the Young's modulus of the substrate, and is a fixed parameter of the substrate. $\Delta d$ is the interplanar spacing difference at different positions; $d_0$ is the theoretical interplanar spacing; and $\sigma$ is the stress value required to be calculated.

The calculation formula of stress and strain is $\sigma = E \times \Delta d$, where E is the Young's modulus of the substrate and is a fixed parameter of the substrate; $\Delta d$ is the interplanar spacing difference at different positions; and $\sigma$ is the stress value required to be calculated.

The Raman test points are set first, either for a single point test or for a Mapping scan of the entire substrate. Therefore, the single-point test is a set of scattered coordinate points, and the Mapping scanning is from 10x10 to 50x50 and more points. A suitable test method can be selected according to the properties of the substrate to determine the Raman test coordinate diagram of the silicon carbide substrate.

The results of the test, including but not limited to editable peak positions, peak intensity data, and Mapping, are then output.

The output data is then subjected to a peak position fit using a function including, but not limited to, Gaussian, Lorentz, GaussLor, AGauss, Aloren, and AGaussLor to obtain an accurate peak value and peak position offset with the peak position accurate to more than one decimal place.

Finally, according to the peak position offset and stress conversion coefficient $\mu$ calculated in (1) and the peak position offset $\Delta v$ obtained in Raman test, the stress value of silicon carbide is calculated, and the calculation formula is as follows: $\sigma$ (MPa) $= \mu \times \Delta v$ (cm$^{-1}$). Finally, a stress test image of the substrate is obtained.

It is difficult to ensure that the surface of SiC is completely horizontal, that is, there is a certain degree of bending warpage because of a large amount of external mechanical stress in the process of preparing the wafer from the crystal through serial processing. In order to eliminate the influence of the substrate surface curvature on the substrate surface stress and internal stress test, it is necessary to first perform the substrate curvature test. According to the curvature, the substrate surface stress selects the equidistant focus test, and the substrate internal stress selects the equidistant focus test or the uniform focus plane test.

After the bending test, it is necessary to use single crystal silicon to calibrate the tester. Firstly, the Z-Mapping test is performed on single crystal Si to confirm that it is Gaussian distribution. Taking the surface of single crystal Si substrate as the zero point, the axial Mapping test is performed from -100 $\mu$m in a single crystal Si substrate to + 20 $\mu$m above the single crystal Si substrate to analyze the change of Raman signal intensity. The single crystal Si substrate is non-transparent material. Thus, its peak intensity presents Gaussian distribution, and the position of surface zero point is taken as the symmetry axis. The single crystal Si is then subjected to a surface-focused single-point test and a single crystal Si Raman peak position is made to 520.70 cm$^{-1}$ by the instrument, which indicates that the instrument's optical path has been calibrated.

The axial measurement of 4H-SiC substrate in Z direction is performed by the calibrated instrument. The Raman laser shines from -100 $\mu$m in the 4H-SiC substrate to + 20 $\mu$m above the 4H-SiC substrate. 4H-SiC and other silicon carbide have the characteristics of transparent materials. Therefore, the Raman laser shines into the silicon carbide substrate, and the feedback signal gradually decreases with the increase of the incident depth of Raman laser. Other silicon carbide substrates include semi-insulating, conductive and 3C, 4H, 15R, 6H and other different forms of silicon carbide substrates. Thus, the Raman peak intensity of silicon carbide substrate gradually decreases with the increase of the depth of the Raman laser into the silicon carbide substrate.

By means of the auto-focusing function of the Raman device, the strongest peak of the test signal on the substrate surface can be automatically set, so that the bending degree of the substrate surface can be measured by means of this function. The specific method is as follows.

S1, firstly, it ensures the level of test platform, a fixed origin (0, 0) is selected on the test platform, and this point is marked as three-dimensional coordinates (0, 0, 0);

S2, according to the thickness of the substrate, the objective lens is raised to a height which is not in contact with the substrate so as to automatically focus at any point to the position where the test signal on the substrate surface is strongest. This position is marked as (a, b, c), and then the distance that the Raman laser moves downwards is adjusted by H, and the position is focused at (a, b, c-H);

S3, the Raman laser test position is adjusted to (0, 0, c-H) to perform a uniform focus plane test to obtain a two-dimensional peak intensity scan pattern of the substrate surface. According to the peak intensity distribution relationship of the silicon carbide substrate and the two-dimensional peak intensity scan pattern of the substrate surface, the distance between the focus plane of the Raman laser and the silicon carbide substrate surface can be obtained. Thus, the in-plane bending condition of the substrate can be obtained, and the in-plane bending distribution pattern of the substrate can be obtained.

The thermal stress and residual stress exist in the crystal due to the influence of temperature field and inclusion in the crystal growth process, and the substrate is obtained after the crystal is cut, ground and polished by a series of processes. The above-mentioned process of crystal forming the substrate may cause the surface lattice distortion and thus generate surface stress. In order to further distinguish the surface stress from the internal stress of the substrate, according to the light transmission characteristics of silicon carbide, the axial test of the substrate, namely Z-direction Mapping, is performed with the substrate surface as the zero point. The test range of the axial test is from -150 $\mu$m to -30 $\mu$m in the substrate to above the substrate surface.

In the test, the laser spot is gradually focused from the inner body of the substrate upwards to the damage stress extension layer, further to the surface damage layer, and then continues to be focused upwards into the air, so as to determine the thickness of the damage layer on the surface of the substrate and the damage stress extension layer. Taking the substrate surface as the zero point, the test range of the axial test is that the Raman laser spot gradually moves from -100 $\mu$m in the substrate to 30 $\mu$m above the substrate surface, and the 5-point tests on the top, bottom, left and right of the substrate are carried out. The 5-point tests on the substrate show the same trend, but there is a difference in the maximum value of the negative stress at the surface damage.

The laser spot gradually increases from -100 $\mu$m up to -30 $\mu$m in the substrate. At this time, the stress fluctuates along the horizontal line, representing that the internal stress in the body is in a uniform state. When the laser spot is focused on the damage stress extension layer, the stress curve begins to show a downward trend at -30 $\mu$m, and the downward trend of stress gradually increases. When the laser spot is close to the zero point of the substrate surface, the maximum value of negative stress is reached, which is the stress value of the surface damage layer. Eventually, the laser spot continues to move upward and gradually away from the substrate surface into air, with the stress appearing as a rapid rise to a turbulent fluctuation. Therefore, the thickness of the surface damage layer and damage stress extension layer of the substrate can be determined according to the axial test results of the substrate, so that the stress in the substrate can be divided into surface stress and internal stress, which provides a theoretical basis for the subsequent quantitative test of surface stress and internal stress in the substrate.

The residual stress exists in the silicon carbide crystal during the PVT growth process due to the temperature gradient change and inclusion disorder. Different from the surface processing stress, the internal stress is located at a certain depth from the surface, which reflects the thermal stress and residual stress of the crystal growth. In addition, the silicon carbide has been subjected to a large number of external mechanical stress in the process of preparing the substrate from the crystal through a series of processing. It is difficult to ensure that the surface is completely horizontal. That is, there is a certain degree of bending warpage on the substrate surface. According to the method for measuring the surface curvature of a substrate obtained by Raman measurement in Example 2, this example relates to a method for quantitatively characterizing the internal stress of silicon carbide, which is not affected by the surface bending and warpage, in combination with the physical properties of silicon carbide.

According to the physical characteristics of light transmittance of silicon carbide, the method for quantitatively characterizing the internal stress of a substrate by using Raman spectroscopy is divided into the equidistant focus test and the uniform focus plane test, and the specific details are as follows:

1. Equidistant focus test

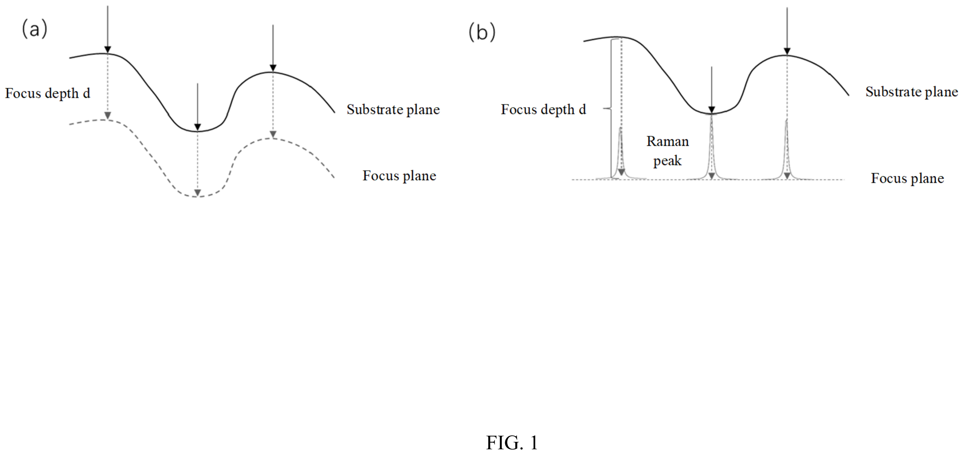

The principle of the equidistant focus test is as shown in FIG. 1 (a). In this test mode, the focus depth (d) of the Raman laser focusing on the inside of the substrate at different positions is kept constant. Firstly, the penetration depth ($D_p$) of the Raman laser is calculated according to the following formula:

$$D_p = \frac{1}{\alpha} = \frac{\lambda}{4\pi k}$$

In the above formula, $D_p$ is the penetration depth of Raman excitation in the sample; $\alpha$ is the absorption coefficient; $\lambda$ is the laser wavelength; and k is the extinction coefficient. The specific value of the penetration depth ($D_p$) is obtained by calculating according to the above formula. An appropriate focus depth (d) chosen under the requirement to be met is that the penetration depth ($D_p$) is greater than the focus depth (d). Since the internal stress is tested, the focus depth d is required to be greater than the thickness of the surface damage layer and damage stress extension layer obtained in the test in Example 3.

The spot diameter (D) of the Raman laser is then calculated according to the following formula:

$$D = \frac{2\lambda}{N_a^2}$$ , where $\lambda$ is the laser wavelength and Na is the numerical aperture of the device.

The diameter of the laser spot (D) is the diameter of the short axis of the laser spot. The larger this value is, the stronger the Raman peak of each test position is, and the more impurity peaks are, which affects the detection accuracy of Raman. In the case of determined $\lambda$, if the Na value is large, the peak intensity is very weak, which will also affect the Raman detection accuracy. Therefore, it is necessary to select suitable $\lambda$ and Na to improve the accuracy of the test method.

According to the characteristics of silicon carbide materials, the peak intensity reaches the maximum when the laser is focused on the substrate surface. Thus, using the auto-focusing function of the Raman tester can realize the laser focusing on the substrate surface, and then according to the above-mentioned determined focus depth (d), so as to realize the equidistant focus test on different positions of the substrate. That is to say, the distance between the focus plane and the substrate surface is always the same. This method is not affected by the bending and warping of the substrate surface, so that the obtained Raman peak intensity always remains at the axial maximum value of the test point. According to the stress quantitative test method in Example 1, the internal stress test result diagram of the substrate is obtained.

2. Uniform focus plane test,

The principle of the uniform focus plane test is shown in FIG. 1 (b). In this test mode, the focus depth (d) of the Raman laser spot focusing on the inside of the substrate at different positions changes, and the laser spot is focused on the same plane inside the substrate at different positions. According to the same formula as that for the uniform focus plane test, the penetration depth ($D_p$) of the Raman laser is calculated and the appropriate focus depth (d) is selected in the same selection mode.

Since the focus planes in this test method are equal, in combination with the characteristics of silicon carbide, the peak intensity reaches the maximum when the laser is focused on the substrate surface and the signal gradually decays with the increase of the focus depth. Also, the effective signal-to-noise ratio is tested according to the Raman tester, and it is found that the effective signal-to-noise ratio is inversely correlated with the Raman laser focus depth (d). Therefore, in this test method, the focus depth (d) at different positions is required to be combined with the bending degree of the substrate so as to obtain the effective peak position offset by the stress quantitative test method of Example 1, thereby reducing the error in the internal stress test and obtaining a graph of internal stress test results of the substrate.

By the above-mentioned two test methods including the equidistant focus test and the uniform focus plane test, the peak position offset in the substrate is obtained respectively, and the internal stress distribution of the substrate is calculated. The error of internal stress value of the substrate calculated by the two test methods including the equidistant focus test and the uniform focus plane test is ≤ 0.2 MPa, and the difference of peak position value obtained by the two test methods including the equidistant focus test and the uniform focus plane test is less than 0.0005 cm$^{-1}$. The above-mentioned two methods can verify the accuracy of the quantitative detection method of the present application, and the accuracy of the test method can be further improved according to the settings of the focus depth and the light spot diameter.

Examples

The present example relates to a method for preparing a TaC coating having through-type through holes, including the steps below.

(1) Preparation of the slurry: 25-40 parts of TaC powder, 5-8 parts of $Ta_2O_5$, 20-35 parts of a solvent, 15-25 parts of a co-solvent, 1-3 parts of an air-entraining agent, 2-5 parts of a thickener, 5-15 parts of a linear saturated aliphatic hydrocarbon and 1-3 parts of carbon powder are mixed and stirred at 700-800 r/min for 2-3 h to obtain a slurry containing TaC.
(2) The slurry is sprayed onto a surface with a graphite substrate, increasing the temperature to 60-80°C, maintaining same for 2-4 h for bubble bursting, and then drying at 180-220°C for 8-12 h; and sintering at 700-900 mbar and 500-700°C for 3-5 h. Then, with the pressure increased to 1000-1100 mbar and the temperature increased to 1600-1800°C, the sintering is performed for 8-10 h. Subsequently, with the pressure adjusted to 145-155 kPa and the temperature increased to 2200-2400°C, with the sintering is performed for 14-16 h. Finally, the temperature is decreased to room temperature and normal pressure within 15-25 h, thereby obtaining a TaC coating with through-type through holes.

Crucibles 1#-8# and comparative crucibles D1#-D3# are prepared according to the preparation method described above, and the details are as follows.

(1) Preparation of the slurry: 32.7 parts of TaC powder, 6 parts of $Ta_2O_5$, 25 parts of ethanol, 20 parts of tetrahydrofuran, 1.5 parts of a saponin-based air-entraining agent, 3.5 parts of cellulose ether, 10 parts of linear saturated aliphatic hydrocarbon and 1.3 parts of carbon powder are mixed, and stirred at 700 r/min for 2.5 h to obtain a slurry containing TaC.
(2) The slurry of step (1) is electrostatically sprayed onto the surface of a graphite substrate, increasing the temperature to 70°C, maintaining the same for 3 h to break bubbles, and drying at 200°C for 10 h, followed by sintering. It is sintered at 800 mbar and 600°C for 4 h. Then, with the pressure increased to 1000 mbar and the temperature increased to 1700°C, the sintering is performed for 9 h. Subsequently, with the pressure adjusted to 150 kPa, and the temperature raised to 2300 C, the sintering is performed for 15 hours. Finally, the temperature is decreased to room temperature and normal pressure within 20 hours, thereby manufacturing a crucible 1#.

(1) Preparation of the slurry: 25 parts of TaC powder, 5 parts of $Ta_2O_5$, 20 parts of ethanol, 15 parts of tetrahydrofuran, 1 part of a saponin-based air-entraining agent, 2 parts of cellulose ether, 5 parts of linear saturated aliphatic hydrocarbon and 1 part of carbon powder are mixed and stirred at 800 r/min for 2 h to obtain a slurry containing TaC.
(2) The slurry of step (1) is electrostatically sprayed onto the surface of a graphite substrate, increasing the temperature to 60°C, maintaining the same for 4 h to break bubbles, and drying at 180°C for 12 h, followed by sintering. The sintering is performed at 700 mbar and 500°C for 5 h. Then, with the pressure increased to 1000 mbar and the temperature is increased to 1600°C, the sintering is performed for 10 h. Subsequently, with the pressure adjusted to 145 kPa and the temperature increased to 2200°C, the sintering is performed for 16 hours. Finally, the temperature is decreased to room temperature and normal pressure within 15 hours, thereby manufacturing a crucible 2#.

(1) Preparation of the slurry: 40 parts of TaC powder, 8 parts of $Ta_2O_5$, 35 parts of ethanol, 25 parts of tetrahydrofuran, 3 parts of a saponin-based air-entraining agent, 5 parts of cellulose ether, 15 parts of linear saturated aliphatic hydrocarbon and 3 parts of carbon powder are mixed and stirred at 700 r/min for 3 h to obtain a slurry containing TaC.
(2) The slurry of step (1) is electrostatically sprayed onto the surface of a graphite substrate, increasing the temperature to 80°C, maintaining the same for 2 h to break bubbles, and drying at 220°C for 8 h, followed by sintering. The sintering is performed at 900 mbar and 700°C for 3 h. Then, with the pressure increased to 1100 mbar and the temperature increased to 1800°C, the sintering is performed for 8 h. Subsequently, with the pressure adjusted to 155 kPa and the temperature increased to 2400°C, the sintering is performed for 14 hours. Finally, the temperature is decreased to room temperature and normal pressure within 25 hours, thereby manufacturing a crucible 3#.

This example is different from the crucible# 1 in that in step (1), raw materials are mixed and then stirred at 700 r/min for 5 min, and the rest conditions are the same as the crucible 1# to prepare a crucible 4#.
This example differs from the crucible 1# in that in step (2), the slurry of step (1) is electrostatically sprayed onto the surface of the graphite substrate, raised to a temperature of 200°C, maintained for 13 h for bubbles breaking and drying, and then followed by the sintering. The rest conditions are the same as the crucible 1# to prepare a crucible 5#.
This example differs from crucible 1# in that in step (2), the sintering is as follows. The sintering is performed at 400 mbar and 400°C for 4 h. Then, with the pressure increased to 1000 mbar and the temperature increased to 1700°C, the sintering is performed for 9 h. Subsequently, with the pressure adjusted to 150 kPa and the temperature increased to 2300°C, the sintering is performed for 15 h. Finally, the temperature is decreased to room temperature and normal pressure within 20 h, and the rest conditions are the same as those of crucible 1#, i. e., the crucible 6# is prepared.

This example differs from the crucible 1# in that in step (2), the sintering is as follows. The sintering is performed at at 800 mbar and 600°C for 4 h. Then, with the pressure increased to 1000 mbar and the temperature increased to 1200°C, the sintering is performed for 9 h. Subsequently, with the pressure adjusted to 150 kPa and the temperature increased to 2300°C, the sintering is performed for 15 h. Finally, the temperature is decreased to room temperature and normal pressure within 20 h, and the rest conditions are the same as those of crucible 1 #, i. e., a crucible 7# is prepared.

This example differs from the crucible 1# in that in step (2), the sintering is as follows. The sintering is performed at 800 mbar and 600°C for 4 h. Then, with the pressure increased to 1000 mbar and the temperature increased to 1700°C, the sintering is performed for 9 h. Subsequently, with the pressure adjusted to 120 kPa and the temperature increased to 2500°C, the sintering is performed for 15 h. Finally, the temperature is decreased to room temperature and normal pressure within 20 h, and the rest conditions are the same as those of the crucible 1#, i. e., a crucible 8# is prepared.

In this comparative example, as compared with the crucible 1#, the TaC coating is prepared by the CVD method.

Specifically, the graphite substrate is placed into a chemical vapour deposition furnace, which is evacuated to not more than 50 Pa, and then increased to 1200°C, with a mixed gas composed of ethane, $taCl_5$, $H_2$ and argon as a carrier gas introduced. The mixed gas maintained at a stable flow rate flows into the deposition furnace, maintaining the furnace pressure at 5000 Pa. Firstly, the molar ratio of $TaCl_5$ to ethane gas is controlled at 1.2 : 1 to form a transition layer with a thickness of 50 $\mu$m. Then, the molar ratio of $TaCl_5$ to ethane gas is controlled to be 3 : 1 to form a coating layer having a thickness of 60 mTaC, i. e., a comparative crucible D1# is prepared.

In this comparative example, compared with crucible 1#, the raw materials in the slurry in step (1) are different in that BYK defoamer is used to replace the saponin-based air-entraining agent, and the rest conditions are the same as those of the crucible 1#, i. e., a comparative crucible D2# is prepared.

In this comparative example, compared with the crucible 1#, the raw materials in the slurry in step (1) are different in that a comparative crucible D3# is prepared by replacing $Ta_2O_5$ with $TaCl_5$ under the same conditions as those of the crucible 1#.

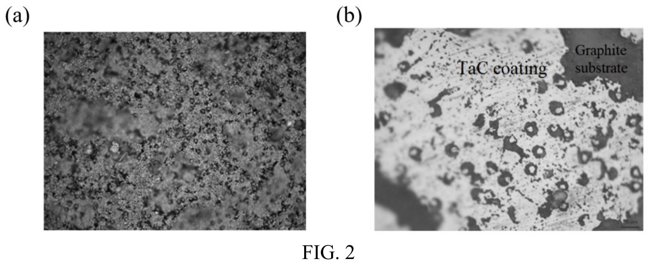

The cross-sectional SEM test and the EDS energy spectrum analysis are performed on the crucibles 1#-8# prepared above and the comparative crucibles D1#-D3#. It can be seen from FIG. 2 that FIG. 2 (a) shows the appearance of the TaC coating with through-type through holes under a microscope, and holes with similar appearance and size are uniformly distributed on the surface of the coating. FIG. 2 (b) demonstrates that through holes are through-type through hole when polishing the coating until the substrate graphite is exposed, at which time the holes are still visible. The XRD test of TaC coating shows that the TaC grains of TaC coating grow along the [200] and [220] directions. The thickness of the formed TaC coating, the average pore diameter and density of the through-type through hole in the TaC coating as well as the size of the TaC grain are tested, and the test results are shown in Table 1.

Table 1

| [Table 1_sm_0001] | | | | |
|---|---|---|---|---|
| Samples | Thickness ($\mu$m) | Average pore diameter of the through-type through hole ($\mu$m) | Density of the through-type through hole ($\mu$m) | Size of the TaC grain ($\mu$m) |
| Crucible 1# | 42 | 4.7 | 310 | 34 |
| Crucible 2# | 31 | 6.1 | 224 | 31 |
| Crucible 3# | 46 | 4.4 | 293 | 33 |
| Crucible 4# | 42 | 2.3 | 160 | 32 |
| Crucible 5# | 41 | 3.6 | 213 | 41 |
| Crucible 6# | 43 | 3.8 | 181 | 43 |
| Crucible 7# | 42 | 4.7 | 267 | 45 |
| Crucible 8# | 41 | 5.9 | 274 | 38 |
| Comparative crucible D1# | 60 | 0 | 0 | 34 |
| Comparative crucible D2# | 43 | 0 | 0 | 31 |
| Comparative crucible D3# | 42 | 5.6 | 247 | 33 |

The prepared crucibles 1#-8# and the comparative crucibles D1#-D3# are subjected to high-temperature etching and thermochemical etching experiments to simulate the growth environment of the third-generation semiconductor silicon carbide crystal using the PVT method, so that the crucibles 1#-8# and the comparative crucibles D1#-D3# are exposed to 2300°C and subjected to silicon carbide atmosphere etching for 100 h. The test results are shown in table 2.

Table 2

| [Table 1_sm_0002] | | | |
|---|---|---|---|
| Samples | Weight before the experiment (g) | Weight after the experiment (g) | Weight loss rate of erosion (%) |
| Crucible 1# | 753 | 702 | 6.8 |
| Crucible 2# | 714 | 639 | 10.5 |
| Crucible 3# | 742 | 701 | 5.5 |
| Crucible 4# | 747 | 714 | 4.4 |
| Crucible 5# | 760 | 721 | 5.1 |
| Crucible 6# | 741 | 708 | 4.5 |
| Crucible 7# | 755 | 716 | 5.2 |
| Crucible 8# | 749 | 698 | 6.8 |
| Comparative crucible D1# | 797 | 769 | 3.5 |
| Comparative crucible D2# | 761 | 707 | 4.1 |
| Comparative crucible D3# | 759 | 704 | 6.5 |

In Table 2, the weight loss rate of erosion = [(weight before the experiment-weight after the experiment)/weight before the experiment] x 100%. The above-mentioned high-temperature erosion and thermochemical erosion experiments prove that the TaC coating of this example can improve the protective performance to the graphite substrate, and can extend the resistance and corrosion resistance of the TaC coating, thereby extending the service life of the crucible.

The present example relates to a method for preparing a silicon carbide single crystal having a diameter of 150 mm, including the steps below.

(1) Silicon carbide powder is added to a crucible.
(2) The furnace body is evacuated to less than 10-6 mbar, then a high-purity inert gas is introduced to 300-500 mbar, this process is repeated for 2-3 times, and finally the furnace body is evacuated to less than 10-6 mbar.
(3) A high-purity inert gas is introduced into the furnace body, the pressure is increased to 10-100 mbar within 1-3 h, and it continuously introduces the high-purity inert gas and keeps the pressure unchanged.
(4) Growing stage: with the pressure kept constant, the temperature in the furnace body is increased to a single crystal growth temperature of 2200 K-2800 K within 3-5 h, the growth time being 30-150 h.
(5) At the end of single crystal growth, the furnace body is opened, and the graphite crucible is removed to obtain a silicon carbide single crystal.

An equal amount of silicon carbide powder is added to crucibles 1#-3# prepared in Example 6 and comparative crucibles D1#-D3#, respectively. The furnace body is evacuated to less than 10-6 mbar, and then introduced with a high-purity inert gas to 300 mbar. This process is repeated for 3 times, and finally the furnace body is evacuated to less than 10-6 mbar. A high-purity inert gas is introduced into the furnace body, with the pressure increased to 30 mbar within 1 h, the high-purity inert gas continuously introduced and the pressure kept unchanged. Growing stage: the temperature in the furnace body is increased to a single crystal growth temperature of 2500 K within 3 h, and the growth time is 70 h under the condition of keeping the pressure unchanged. At the end of the single crystal growth, the furnace body is opened, and the graphite crucible is taken out to obtain silicon carbide single crystals 1#-3# and comparative silicon carbide single crystals D1#-D3#, respectively.

The silicon carbide substrates 1#-3# and the comparative silicon carbide substrates D1#-D3# which are obtained by subjecting the above silicon carbide single crystals 1#-3# and comparative silicon carbide single crystals D1#-D3# to the same cutting, grinding, mechanical polishing and chemical polishing, are subjected to internal stress tests using the methods of Examples 1-4. The results are shown in Tables 3 and 4.

Table 3

| Samples | Radial internal stress (MPa) | | | | | | |
|---|---|---|---|---|---|---|---|
| | Square area | Annular area | $S_{max2}$-$S_{max1}$ | S1 - S2 | S1/S3 | $\Delta S_1$ | $\Delta S_2$ |
| Silicon carbide substrate 1# | -1.2-4.3 | 5.0-7.1 | 1.8-5.2 | -1.5-2.5 | 0.7-0.86 | 0-5.0 | 0.1-2.0 |
| Silicon carbide substrate 2# | -3.3-5.7 | 5.3-7.9 | 2.8-3.8 | -2.4-3.3 | 0.52-0.87 | 0.3-6.6 | 0.1-2.4 |
| Silicon carbide substrate 3# | -9.4-9.2 | 5.7-14.7 | 3.8-5.1 | -4.8-4.9 | 0.31-0.94 | 1.6-9.5 | 0.8-4.9 |
| Comparative silicon carbide substrate D1# | -10.7-11.8 | 12.7-17.4 | 4.7-10.9 | -5.7-6.5 | 0.13-0.84 | 4.1-20.7 | 0.4-4.7 |
| Comparative silicon carbide substrate D2# | -10.3-11.1 | 11.6-16.9 | 3.9-11.5 | -6.1-5.4 | 0.22-0.81 | 5.2-19.4 | 0.5-5.2 |
| Comparative silicon carbide substrate D3# | -9.4-10.3 | 10.5-16.3 | 5.4-8.6 | -5.3-4.9 | 0.21-0.95 | 3.5-13.4 | 0.4-5.6 |

Table 4

| Samples | Axial internal stress (MPa) | | | | | | |
|---|---|---|---|---|---|---|---|
| | Square area | Annular area | Width of annular area/mm | $\Delta S_3$ | $\Delta S_4$ | S4-S5 | S4/S6 |
| Silicon carbide substrate 1 # | -0.5-0.7 | -4.2-4.3 | 5 | 0.1-1.2 | 0.3-4.4 | -0.4-1.1 | 0.1-0.17 |
| Silicon carbide substrate 2# | 2.3 3.1 | -6.2-8.1 | 16 | 1.3-5.2 | 1.4-8.9 | -1.8-2.7 | 0.33-0.49 |
| Silicon carbide substrate 3# | -9.1-9.4 | -14.5-14.9 | 30 | 1.9-9.7 | 2.1-14.3 | -4.2-4.8 | 0.41-0.79 |
| Comparative silicon carbide substrate D1# | -11.8-15.7 | -16.5-18.6 | 31 | 3.3-25.4 | 4.2-19.5 | -6.8-8.7 | 0.61-0.98 |
| Comparative silicon carbide substrate D2# | -11.1-14.1 | -15.2-15.7 | 25 | 3.4-14.6 | 3.2-16.3 | -5.5-6.2 | 0.54-0.92 |
| Comparative silicon carbide substrate D3# | -10.7-11.6 | -14.5-16.1 | 35 | 2.1-11.2 | 3.5-15.6 | -4.8-5.9 | 0.53-0.81 |

The surface types of the above-mentioned silicon carbide substrates 1#-3# are tested. The bending degrees of the above-mentioned silicon carbide substrates 1#-3# are all in the range of -50 μm to 50 μm. The local thickness deviation in the central area is in the range of 0.1 μm to 2 μm. The local thickness deviation in the annular area is in the range of 0.1 μm to 2 μm.

The stress values in Tables 3 and 4 refer to relative stress values. The positive and negative of the stress values in the present application represent whether the substrate is subjected to a tensile stress or a compressive stress. Currently, when evaluating and describing the final stress of a substrate, it is usually obtained by taking the difference of the maximum value minus the minimum value of the above-mentioned stress values. For example, when the axial stress of the square area of a silicon carbide substrate 1# is -0.5-0.7 MPa, it can also be described in the art as a stress value of 1.2 MPa when generally representing the axial stress of the square area of the silicon carbide substrate 1#.

The data in the above-mentioned Tables 3-4 are only the substrates prepared by using the crucibles 1#-3# prepared in Example 5 and the comparative crucibles D1#-D3#. When the silicon carbide substrate sheet is prepared by using the same crystal growing and processing method in Example 6 and using the crucibles 4#-8#, and the absolute stress is used to characterize the parameters in Tables 3-4, it can satisfy the requirements below. The width of the annular area extending inwards from the edge of the substrate is 5-30 mm. The radial internal stress of the square area is -10 to 10 MPa. The radial internal stress of the annular area is 5-15 MPa. $1.8\ MPa \leq S_{max2} - S_{max1} \leq 5.2MPa$; $-5\ MPa \leq S1 - S2 \leq 5$ MPa; $0.3 \leq S1/S3 \leq 0.94$; $0\ MPa \leq \Delta S_1 \leq 10MPa$; $0\ MPa \leq \Delta S_2 \leq 5\ MPa$. The axial internal stress in the square area is -10 to 10 MPa, and the axial internal stress in the annular area is -15-15 MPa. $0\ MPa \leq \Delta S_3 \leq 10\ MPa$; $0\ MPa \leq \Delta S_4 \leq 15\ MPa$; $-5\ MPa \leq S4 - S5 \leq 5\ MPa$; $0.1 \leq S4/S6 \leq 0.8$.

What has been described above is merely examples of the present application. The scope of the present application is not limited to these specific examples, but rather is determined by the claims of the present application. Various modifications and alterations of this application will become apparent to those skilled in the art. Any modification, equivalent substitution, improvement, etc. made within the technical ideas and principles of the present application shall be included within the protection scope of the present application.

**Claims**

1. A silicon carbide substrate having a high crystal quality, wherein the diameter of the silicon carbide substrate is 150 mm or more; the silicon carbide substrate comprises a first main surface and a second main surface;

   the first main surface has a central area and an annular area surrounding the central area, the width of the annular area extending inward from an edge of the substrate being 5-30 mm; and
   the central area is divided into square areas, each having a side length of 5 mm, the internal stress of each square area being less than the internal stress of the annular area, and the internal stress being the stress value detected at least 30 $\mu$m vertically extending from the first main surface or the second main surface into the silicon carbide substrate.

2. The silicon carbide substrate according to claim 1, wherein the radial internal stress of the square area is -10 to 10 MPa and the radial internal stress of the annular area is 5 to 15 MPa at any plane parallel to the first main surface and/or the second main surface.

3. The silicon carbide substrate according to claim 1, wherein, at any plane parallel to the first main surface and/or the second main surface, $S_{max1}$ represents a maximum value of an absolute value of the radial internal stress in all of the square areas, and $S_{max2}$ represents a maximum value of the absolute value of the radial internal stress in the annular area, $1.8\ MPa \leq S_{max2} - S_{max1} \leq 5.2\ MPa$.

4. The silicon carbide substrate according to claim 1, wherein, at any plane parallel to the first main surface and/or the second main surface, S1 represents an average value of absolute values of radial internal stresses in all of the square areas, and S2 represents an average value of absolute values of radial internal stresses in any of the square areas, $-5\ MPa \leq S1 - S2 \leq 5\ MPa$.

5. The silicon carbide substrate according to claim 1, wherein, at any plane parallel to the first main surface and/or the second main surface, S1 represents an average value of absolute values of radial internal stress in all of the square areas, S3 represents an average value of absolute values of radial internal stresses in the annular area, $0.3 \leq S1/S3 \leq 0.94$.

6. The silicon carbide substrate according to claim 1, wherein, at any plane parallel to the first main surface and/or the second main surface, $S_{max3}$ represents a maximum value of radial internal stresses in any of the square areas, and $S_{min3}$ represents a minimum value of radial stresses in any of the square areas, $\Delta S_1 = S_{max3} - S_{min3}$, $0\ MPa \leq \Delta S_1 \leq 10$ MPa;
   $S_{max4}$ represents a maximum value of radial internal stresses in the annular area, and $S_{min4}$ represents a minimum value of the radial stresses in the annular area, $\Delta S_2 = S_{max4} - S_{min4}$, $0\ MPa \leq \Delta S_2 \leq 5\ MPa$, at any plane parallel to the first and/or second main surfaces.

7. The silicon carbide substrate according to claim 1, wherein the square area has an axial internal stress of -10 to 10 MPa and the annular area has an axial internal stress of -15 to 15 MPa when tested in an axial direction extending perpendicularly into the silicon carbide substrate from any point of the first main surface.

8. The silicon carbide substrate according to claim 7, wherein an axial test is performed extending perpendicularly into the silicon carbide substrate from any point of the first main surface; $S_{max5}$ is recorded as a maximum value of the axial stresses of the square area on the axis, and S min5 is recorded as a minimum value of the axial stresses of the square area on the axis, $\Delta S_3 = S_{max5} - S_{min5}$, 0 MPa $\leq \Delta S_3 \leq$ 10 MPa;

an axial test is performed extending perpendicularly into the silicon carbide substrate from any point of the first main surface, wherein $S_{max6}$ is recorded as a maximum value of the axial stresses in the annular area, and $S_{min6}$ is recorded as a minimum value of the axial stresses in the annular area, $\Delta S_4 = S_{max6} - S_{min6}$, 0 MPa $\leq \Delta S_4 \leq$ 15 MPa.

9. The silicon carbide substrate according to claim 7, wherein S4 represents an average value of absolute values of axial internal stresses in all of the square areas, and S5 represents an average value of absolute values of radial internal stresses in any of the square areas, -5 MPa $\leq$ S4 - S5 $\leq$ 5 MPa.

10. The silicon carbide substrate according to claim 1, wherein S4 represents an average value of absolute values of axial internal stresses in all of the square areas, and S6 represents an average value of absolute values of axial internal stresses in the annular area, 0.1 $\leq$ S4/S6 $\leq$ 0.8.

FIG. 1

(a)

(b)

FIG. 2

## INTERNATIONAL SEARCH REPORT

| | International application No. |
|---|---|
| | **PCT/CN2023/143064** |

| A. | CLASSIFICATION OF SUBJECT MATTER |
|---|---|

C30B29/36(2006.01)i;  C30B23/00(2006.01)i;  C30B23/02(2006.01)i

According to International Patent Classification (IPC) or to both national classification and IPC

| B. | FIELDS SEARCHED |
|---|---|

Minimum documentation searched (classification system followed by classification symbols)

IPC: C30B29/-, C30B23/-

Documentation searched other than minimum documentation to the extent that such documents are included in the fields searched

Electronic data base consulted during the international search (name of data base and, where practicable, search terms used)

CNTXT, DWPI, CNKI, STN: 碳化硅, sic, 衬底, 晶圆, 晶片, 环形, 应力, silicon carbide, substrate, wafer, annular, stress

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 113652749 A (SICC CO., LTD.) 16 November 2021 (2021-11-16) description, paragraphs 11-38, and figure 18 | 1-10 |
| A | CN 112048768 A (GLOBALWAFERS CO., LTD.) 08 December 2020 (2020-12-08) entire document | 1-10 |
| A | CN 113957533 A (SICC CO., LTD.) 21 January 2022 (2022-01-21) entire document | 1-10 |
| A | JP 2015059072 A (NIPPON STEEL & SUMIKIN MATERIALS CO., LTD.) 30 March 2015 (2015-03-30) entire document | 1-10 |

| ☐ Further documents are listed in the continuation of Box C. | ☑ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **25 March 2024** | **29 March 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| International application No. |
|---|
| **PCT/CN2023/143064** |

| Patent document cited in search report | | | Publication date (day/month/year) | Patent family member(s) | | | Publication date (day/month/year) |
|---|---|---|---|---|---|---|---|
| CN | 113652749 | A | 16 November 2021 | None | | | |
| CN | 112048768 | A | 08 December 2020 | None | | | |
| CN | 113957533 | A | 21 January 2022 | None | | | |
| JP | 2015059072 | A | 30 March 2015 | JP | 5931825 | B2 | 08 June 2016 |

Form PCT/ISA/210 (patent family annex) (July 2022)